# EUROPÄISCHE PATENTSCHRIFT

(11) **EP 0 696 849 B1**
(45) Veröffentlichungstag und Bekanntmachung des Hinweises auf die Patenterteilung: **03.12.2003**
(21) Anmeldenummer: 95111388.5
(22) Anmeldetag: 20.07.1995
(51) Int. Cl.: H03K 17/082

(54) **Steuergerät mit einer Schaltungsanordnung zum Schutz des Steuergerätes bei Unterbrechung der Steuergerätemasse**
Control apparatus with a circuit arrangement for its protection when the earth connection is interrupted
Appareil de commande avec un circuit pour sa protection en cas d'interruption de sa connexion de terre

(30) Priorität: 09.08.1994 DE 4428115
(43) Veröffentlichungstag der Anmeldung: 14.02.1996
(73) Patentinhaber: Hella KG Hueck & Co., 59552 Lippstadt (DE)
(72) Erfinder: Thiemann, Hans-Joachim, D-33102 Paderborn (DE); Trinschek, Martin, D-59067 Hamm (DE)

(56) Entgegenhaltungen:
- EP-A- 0 425 035
- EP-A- 0 519 156
- US-A- 4 725 912
- US-A- 4 945 445

## Beschreibung

Die Erfindung betrifft ein Steuergerät mit einer Schaltungsanordnung zum Schutz des Steuergerätes bei Unterbrechung der Steuergerätemasse, insbesondere in Kraftfahrzeugen, mit mindestens einem elektronischen Lastschalter, mit jeweils einer Last, die zwischen dem negativen Pol, einer Spannungsquelle und einer ersten Elektrode des jeweiligen Lastschalters angeordnet ist und über eine zweite Elektrode des Lastschalters mit dem positiven Pol der Spannungsquelle verbindbar ist, und mit einer Ansteuerschaltung, die eine Steuerelektrode des jeweiligen Lastschalters zur Betätigung des Lastschalters ansteuert.

Ein solches Steuergerät ist aus der europäischen Patentanmeldung 0 519 156 bekannt. In dieser Schrift ist bereits ein Problem beschrieben, welches sich daraus ergibt, dass das Steuergerät und damit die Lastschalter mit einer anderen Masseleitung verbunden sind als die angesteuerten Lasten. Eine solche Anordnung ist insbesondere in Kraftfahrzeugen üblich, da hierdurch zumindest eine Masseleitung zwischen dem Steuergerät und der mindestens einen angesteuerten Last eingespart werden kann.

Kommt es nun zu einer Unterbrechung in der zum Steuergerät führenden Masseleitung, so kann das Potential an der Steuerelektrode des elektronischen Lastschalters soweit ansteigen, dass dieser teilweise durchschaltet. Hierdurch entsteht am Lastschalter eine relativ hohe Verlustleitung, die zur Zerstörung des Lastschalters führen kann.

Um dieses zu vermeiden, wird für das Steuergerät nach der EPA 0 519 156 folgende Schutzmaßnahme vorgesehen:

Wird die Masseleitung des Steuergerätes unterbrochen, etwa durch Abziehen oder Abgleiten eines Anschlusssteckers, so wird dem Steuergerät mittels einer als Diode ausgebildeten Schutzeinrichtung intern eine Hilfsmasse zur Verfügung gestellt. Diese Hilfsmasse entsteht dadurch, dass im ausgeschalteten Zustand des mindestens einen Lastschalters der Masseanschluß des Steuergerätes über mindestens eine Last und die als Diode ausgebildete Schutzeinrichtung mit der Systemmasse, mit der auch die Lasten in Verbindung stehen, verbunden wird.

Nachteilig an dem vorbekannten Steuergerät ist, dass es nicht gegen Verpolung geschützt ist. Werden nämlich der Masseanschluß und der Spannnungsversorgungsanschluß des Steuergerätes beim Anschluß an die Spannungsquelle vertauscht, so fließt durch die Dioden der Schutzeinrichtung und die Lastschalter ein hoher Strom, der zu einer Zerstörung der Lastschalter führen kann.

Es ist daher die Aufgabe der Erfindung, ein Steuergerät zu schaffen, bei dem der oder die Lastschalter bei einem Bruch der Masseleitung auf besonders einfache und kostengünstige Weise gegen Überlastung geschützt werden können und das zudem gegen eine Verpolung der Spannungsquelle geschützt ist.

Diese Aufgabe wird erfindungsgemäß dadurch gelöst, dass zwischen die Verbindungspunkte von Lastschaltern und Lasten und den Masseanschluß des Steuergerätes eine Schutzeinrichtung geschaltet ist, die aus einer Reihenschaltung, aus einer Diode je Verbindungspunkt und einem PTC-Widerstand besteht.

Durch das Einfügen des PTC-Widerstandes kann somit das Steuergerät auf überraschend einfache Weise verpolsicher ausgeführt werden. Hierbei wird vorteilhafterweise auch bei mehreren zu schützenden Lastschaltern nur ein PTC-Widerstand benötigt. Ein besonderer Vorteil ist darin zu sehen, dass im regulären Betrieb des Steuergerätes (d.h. ohne Unterbrechung der Steuergerätemasse) der PTC-Widerstand die Temperatur des Steuergerätes überwachen kann.

Weitere vorteilhafte Ausgestaltungen und Weiterbildungen gehen aus den Unteransprüchen hervor.

So ist es vorteilhaft, wenn die Ansteuerschaltung eine Spannungsüberwachungseinrichtung aufweist, die ein an der Schutzeinrichtung vorliegendes Potential überwacht. Sofern vorgesehen ist, dass das Steuergerät alle Lasten gleichzeitig ansteuern kann, fällt in diesem Fall die Hilfsmasse am Masseanschluß des Steuergerätes fort.

Dieses wird durch die Spannungsüberwachungseinrichtung erkannt, worauf die Ansteuerschaltung die weitere Ansteuerung der Lastschalter einstellt. Eine solche in die Ansteuerschaltung integrierte Spannungsüberwachung verursacht dabei nur einen unwesentlichen Kostenanteil der Ansteuerschaltung.

Es zeigen:
- Figur 1: ein erstes Ausführungsbeispiel eines erfindungsgemäßen Steuergerätes mit diskret ausgeführten Lastschaltern;
- Figur 2: eine zweite Ausführungsform eines erfindungsgemäßen Steuergerätes mit integrierten Lastschaltern;
- Figur 3: eine dritte Ausführungsform eines erfindungsgemäßen Steuergerätes mit einer abgewandelt ausgeführten Schutzeinrichtung;
- Figur 4: ein Steuergerät nach dem Stand der Technik.

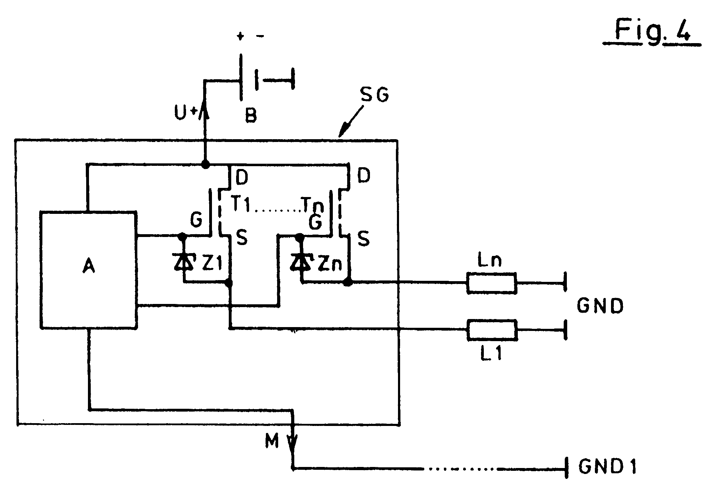

Anhand der Figur 4 soll zunächst die der Erfindung zugrundeliegende Problematik näher ausgeführt werden.

Zu dem in der Figur 4 dargestellten Steuergerät (SG) gehören ein oder mehrere Lastschalter (allgemein n Stück) von denen in der Figur 4 zwei Lastschalter (T1, Tn) beispielhaft dargestellt sind. Die Lastschalter sind hier als Leistungs-MOS-Feldeffekttransistoren ausgeführt. Als übliche Maßnahme zum Schutz vor Überspannung ist parallel zur Source-Gate-Strecke jedes Lastschalters (T1, Tn) eine Zener-Diode (Z1, Zn) geschaltet.

Das Steuergerät (SG) kann über die Lastschalter (T1, Tn) Lasten (L1, Ln) mit dem positiven Pol (+) einer Spannungsquelle (B) verbinden. Die außerhalb des Steuergerätes angeordneten Lasten (L1, Ln) stehen mit der Systemmasse (GND) (beispielsweise in einem Kraftfahrzeug der Kraftfahrzeugkarosserie) in Verbindung. Zur Ansteuerung der Lastschalter (T1, Tn) besitzt das Steuergerät eine Ansteuerschaltung (A). Zum Einschalten eines Lastschalters (T1, Tn) beaufschlagt die Ansteuerschaltung (A) die Gate-Elektrode (G) des Lastschalters (T1, Tn) mit einem positiven Potential und zum Sperren des Lastschalters (T1, Tn) entsprechend mit einem Potential, welches in der Nähe des Massepotentials liegt.

Hierzu ist die Ansteuerschaltung (A) sowohl mit dem positiven Pol (+) der Spannungsquelle (B) als auch über den Masseanschluß (M ) des Steuergerätes (SG) mit einer eigenen Masseleitung (im folgenden als Steuergerätemasse GND1 bezeichnet) verbunden.

Erfolgt durch einen Fehler (Kabelbruch, abgleitender Anschlußstecker oder ähnliches) eine Unterbrechung der Steuergerätemasse (in der Zeichnung angedeutet durch ein punktiertes Linienstück), so kann die Ansteuerschaltung (A) den Steuerelektroden (G) der Lastschalter (T1, Tn) nicht das zum Sperren nötige Potential zur Verfügung stellen.

Über die Ansteuerschaltung (A) gelangt nun ein mehr oder weniger hohes Potential an die Steuerelektroden (G) der Lastschalter, welches zum Einschalten der Lasten führt.

Schlimmer noch ist es, wenn es bei nicht ausreichend hohem Potential an der Steuerelektrode (G) der Lastschalter (T1, Tn) zu einem undefinierten Schaltzustand, etwa einem teilweisen Durchschalten der Lastschalter kommt, bei welchen eine hohe Verlustleistung an den Lastschaltern auftritt und zu deren Zerstörung führt.

Es sind Schutzschaltungen für solche Steuergeräte bekannt, bei denen jedem Lastschalter ein weiterer (in der Figur nicht dargestellter) Transistor zugeordnet wird, welcher bei Unterbrechung der Steuergerätemasse die Gate-Elektrode (G) und die Source-Elektrode (S) jedes MOS-Feldeffekttransistors kurzschließt und so den Lastschalter sperrt.

Besonders bei Steuergeräten mit einer größeren Anzahl von Lastschaltern stellen diese zusätzlich benötigten Transistoren einen erheblichen Kostenfaktor dar.

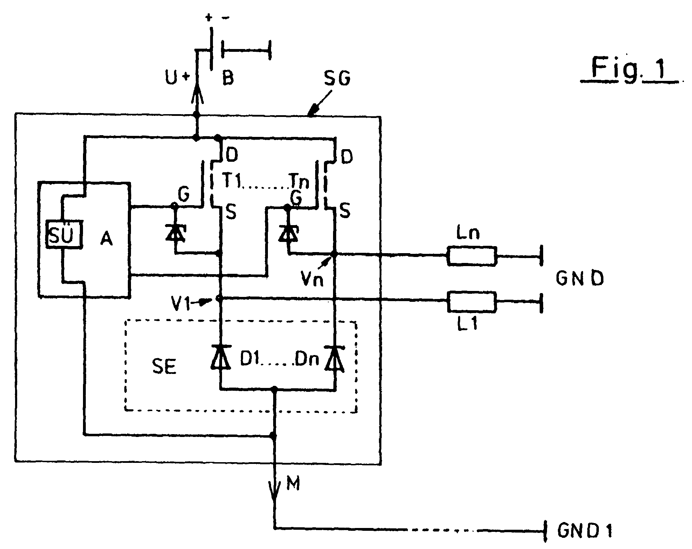

Weitaus kostengünstiger ist demgegenüber die erfindungsgemäße Lösung, die in drei Ausführungsbeispielen in Figuren 1 bis 3 dargestellt ist.

Die Figur 1 zeigt ein Steuergerät (SG) mit einer erfindungsgemäß ausgebildeten Schutzeinrichtung (SE). Hierbei ist jedem zu schützenden Lastschalter (T1, Tn) eine Diode (D1, Dn) zugeordnet, deren Kathode mit dem Verbindungspunkt (V1, Vn) von Lastschalter (T1, Tn) und Last (L1, Ln) verbunden ist.

Anodenseitig sind alle Dioden (D1, Dn) miteinander und mit dem Masseanschluß (M) des Steuergerätes verbunden.

Die durch diese Anordnung von Dioden (D1, Dn) ausgebildete Schutzeinrichtung (SE) stellt im Falle einer Unterbrechung der Steuergerätemasse (GND1) der Ansteuerschaltung (A) eine Hilfsmasse zur Verfügung.

Die Funktionsweise eines Steuergerätes mit einer erfindungsgemäßen Schutzeinrichtung (SE) soll im folgenden anhand der Figur 1 näher erläutert werden:

Die Ansteuerschaltung (A) kann jede Last (L1, Ln) jeweils durch Beaufschlagung der Steuerelektrode (G) des zugeordneten Lastschalters (T1, Tn) mit einem hohen Potential mit dem Pluspol (+) der Spannungsquelle verbinden oder die Lastschalter (T1, Tn) durch Beaufschlagung der Steuerelektrode mit einem niedrigen Potential sperren und damit die zugeordnete Last (L1, Ln) abschalten.

Fällt nun durch eine Unterbrechung der Steuergerätemasse (GND1) das Massepotential am Masseanschluß (M) des Steuergerätes fort und sei angenommen, daß zumindest eine der Lasten nicht eingeschaltet ist, so erhält der Masseanschluß (M) des Steuergerätes über die nicht eingeschaltete Last (L1, Ln) und die zugehörige Diode (D1, Dn) Massepotential von der Systemmasse (GND) zugeführt und kann seine Funktion fortsetzen.

Das am Masseanschluß (M) vorliegende Massepotential fällt allerdings in dem Fall weg, daß die Ansteuerschaltung alle Lasten gleichzeitig ansteuert. Sofern die Funktion des Steuergerätes eine gleichzeitige Ansteuerung aller Lasten ermöglicht, wird für die Ansteuerschaltung eine Spannungsüberwachungseinrichtung (SÜ) vorgesehen. Diese Spannungsüberwachungseinrichtung (SÜ) überwacht die an der Ansteuerschaltung (A) anliegende Betriebsspannung und damit das am Masseanschluß des Steuergerätes anliegende Potential. Werden nun bei unterbrochener Steuergerätemasse (GND1) alle Lasten (L1, Ln) gleichzeitig eingeschaltet, sinkt die Spannung an der Spannungsüberwachungseinrichtung (SÜ) ab. Die Ansteuerschaltung (A), die beispielsweise durch einen Mikroprozessor realisiert sein kann, erkennt aufgrund des Absinkens der Spannung, daß eine Unterbrechung der Steuergerätemasse vorliegt und wird die weitere Ansteuerung der Lasten (L1, Ln) verhindern. Die so erweitere Schutzeinrichtung funktioniert auch in dem Fall, daß die Masseunterbrechung zu einem Zeitpunkt auftritt, an dem alle Lasten gleichzeitig eingeschaltet sind.

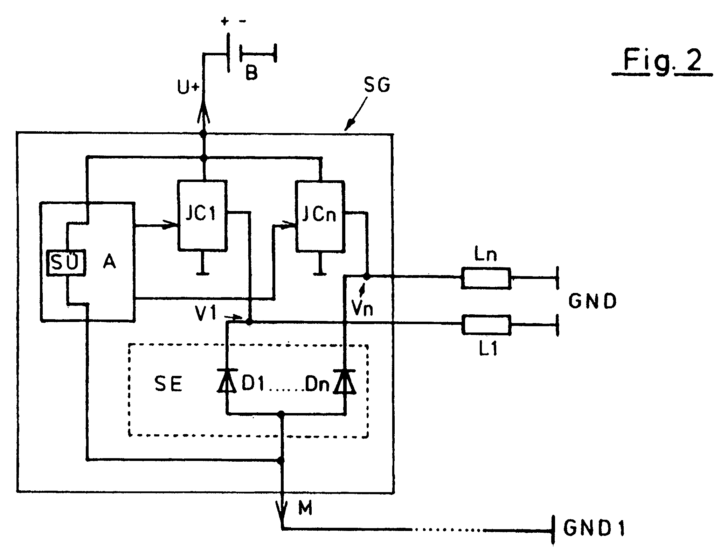

Figur 2 zeigt eine gleichartige Schaltung, die statt diskret ausgebildeten Lastschaltern integrierte Lastschalter (IC1, ICn) (sogenannte High-Side-Treiber) aufweist. Solche integrierten Lastschalter (IC1, ICn) ermöglichen eine vereinfachte Ansteuerung, wodurch die zur Ansteuerung verwendete Ansteuerschaltung einen einfacheren Aufbau aufweisen kann. In der grundsätzlichen Funktionsweise unterscheidet sich dieses Steuergerät nicht von dem in der Figur 1 dargestellten.

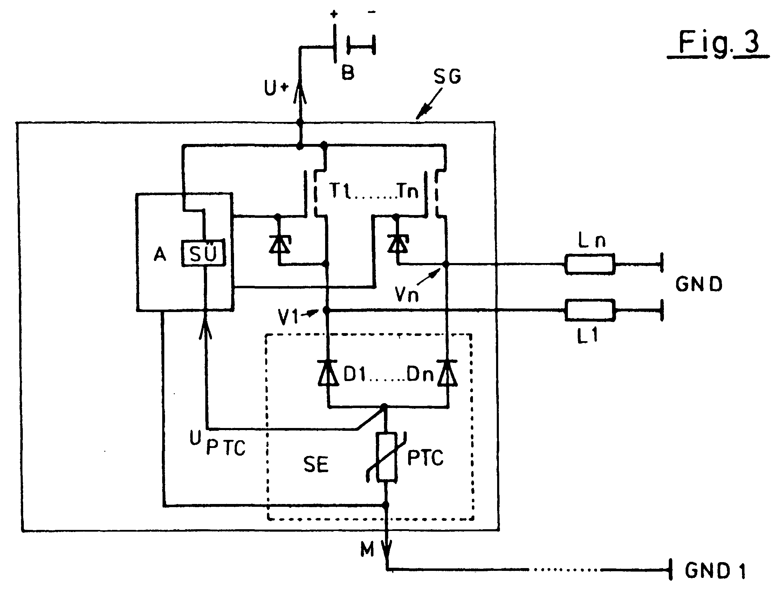

Eine vorteilhafte Variante des in der Figur 1 dargestellten Steuergerätes zeigt die Figur 3. Hier gehört zur Schutzeinrichtung (SE) ein PTC-Widerstand (PTC), der mit den anodenseitig verbundenen Dioden (D1, Dn) in Reihe geschaltet ist. Hierdurch wird das Steuergerät gegen Verpolung geschützt. Wird nämlich bei einer Schaltung nach Figur 1 oder Figur 2 versehentlich der positive Pol (+) der Spannungsquelle (B) mit dem Masseanschluß (M) des Steuergerätes und der negative Pol (-) der Spannungsquelle (B) mit dem Spannungsversorgungseingang (U+) des Steuergerätes verbunden, so fließt über die Reihenschaltung aus Dioden und Lastschalter jeweils ein sehr hoher Strom der zur Zerstörung der Lastschalter (T1, Tn, IC1, ICn) führt.

Bei der Schaltung gemäß Figur 3 wirkt der PTC-Widerstand (PTC) in diesem Fall als strombegrenzender Widerstand, der durch den PTC-Widerstand (PTC) fließende Strom erwärmt diesen und vergrößert dadurch noch seinen Widerstand. Hierdurch wird der Strom durch PTC-Widerstand, Dioden und Lastschalter auf ein für die Lastschalter (T1, Tn, IC1, ICn) ungefährliches Maß reduziert.

Vorteilhaft ist, wenn die Spannungsüberwachungseinrichtung (SÜ) der Ansteuerschaltung (A) das Potential am Verbindungspunkt zwischen dem PTC-Widerstand (PTC) und den Dioden (D1, Dn) überwacht. Unterschreitet die Spannung (U PTC) einen vorgegebenen Wert, so verhindert die Ansteuerschaltung eine weitere Ansteuerung der Lastschalter. Hierbei erkennt die Ansteuerschaltung nicht nur, wie bei einer Schaltung gemäß den Figuren 1 und 2 eine unterbrochene Steuergerätemasseleitung (GND1), sondern auch eine überhöhte Belastung der Hilfsmasse sowie im regulären Betrieb (das heißt ohne Masseunterbrechung) eine unzulässig hohe Erwärmung des Steuergerätes.

## Patentansprüche

1. Steuergerät (SG) mit einer Schaltungsanordnung zum Schutz des Steuergerätes bei Unterbrechung der Steuergerätemasse (GND1), insbesondere in Kraftfahrzeugen, mit mindestens einem elektronischen Lastschalter (T1, Tn, IC1, ICn), mit jeweils einer Last (L1, Ln), die zwischen dem negativen Pol (-) einer Spannungsquelle (B) und einer ersten Elektrode (S) des jeweiligen Lastschalters (T1, Tn, IC1, ICn) angeordnet ist und über eine zweite Elektrode (D) des Lastschalters (T1, Tn, IC1, ICn) mit dem positiven Pol (+) der Spannungsquelle (B) verbindbar ist, und mit einer Ansteuerschaltung (A), die eine Steuerelektrode (G) des jeweiligen Lastschalters (T1, Tn, IC1, ICn) zur Betätigung des Lastschalters (T1, Tn, IC1, ICn) ansteuert, **dadurch gekennzeichnet, dass** zwischen die Verbindungspunkte (V1, Vn) von Lastschaltern (T1, Tn, IC1, ICn) und Lasten (L1, Ln) und den Masseanschluß (M) des Steuergerätes (SG) eine Schutzeinrichtung (SE) geschaltet ist, die aus einer Reihenschaltung, aus einer Diode (D1, Dn) je Verbindungspunkt (V1, Vn) und einem PTC-Widerstand (PTC) besteht.

2. Steuergerät nach Anspruch 1, **dadurch gekennzeichnet, dass** der mindestens eine elektronische Lastschalter als n-Kanal-Leistungs-MOS-Feldeffekttransistor ausgebildet ist.

3. Steuergerät nach Anspruch 1, **dadurch gekennzeichnet, dass** der mindestens eine elektronische Lastschalter als integrierter High-Side-Treiber-Baustein (IC1, ICn) ausgebildet ist.

4. Steuergerät nach Anspruch 1, **dadurch gekennzeichnet, dass** das Steuergerät (SG) mehrere Lastschalter (T1, Tn, IC1, ICn) zur Ansteuerung jeweils einer Last (L1, Ln) aufweist, und dass jeder Verbindungspunkt (V1, Vn) zwischen Last (L1, Ln) und Lastschalter (T1, TN, IC1, ICn) mit dem Kathodenanschluß einer Diode (D1, Dn) verbunden ist und dass zwischen die verbundenen Anoden-Anschlüsse der Dioden (D1, Dn) und den Masseanschluß (M) des Steuergerätes (SG) der PTC-Widerstand (PTC) geschaltet ist.

5. Steuergerät nach Anspruch 1, **dadurch gekennzeichnet, dass** die Ansteuerschaltung (A) eine Spannungsüberwachungseinrichtung (SÜ) das Potential (U_{PTC}) überwacht.

6. Steuergerät nach einem der vorgenannten Ansprüche, **dadurch gekennzeichnet, dass** die Spannungsüberwachungseinrichtung (SÜ) das Potential (U_{PTC}) an den Anoden-Anschlüssen der Dioden (D1, Dn) überwacht und dass die Ansteuerschaltung die Ansteuerung aller Lastschalter(T1, Tn, IC1, ICn) beendet, wenn die Potentialdifferenz zwischen dem überwachten Potential (U_{PTC}) und dem Potential des positiven Pols (+) der Spannungsquelle (B) einen vorgegebenen Wert unterschreitet.

## Claims

1. Controller (SG) with a circuit arrangement for its protection when the controller earth (GND1) is interrupted, particularly in motor vehicles, with at least one electronic power circuit breaker (T1, Tn, IC1, ICn) with a load (L1, Ln) which is arranged between the negative pole (-) of a voltage source (B) and the first electrode (S) of the power circuit breaker (T1, Tn, IC1, ICn) and is connectable via a second electrode (D) of the power circuit breaker (T1, Tn, IC1, ICn) to the positive pole (+) of the voltage source (B), and with a driver circuit (A) which drives a control electrode (G) of the power circuit breaker (T1, Tn, IC1, ICn) to actuate the power circuit breaker (T1, Tn, IC1, ICn), **characterized in that** a protective device (SE) consisting of a series connection of a diode (D1, Dn) for each connection point (V1, Vn) and a positive temperature coefficient resistor (PTC) is connected between the connection points (V1, Vn) of power circuit breakers (T1, Tn, IC1, ICn) and loads (L1, Ln) and the earth connection (M) of the controller (SG).

2. Controller according to Claim 1, **characterized in that** the at least one electronic power circuit breaker is configured as an n-channel power metal-oxide-semiconductor field-effect transistor.

3. Controller according to Claim 1, **characterized in that** the at least one electronic power circuit breaker is configured as an integrated high-side driver module (IC1, ICn).

4. Controller according to Claim 1, **characterized in that** the controller (SG) has a plurality of power circuit breakers (T1, Tn, IC1, ICn) each for driving a load (L1, Ln), and **in that** each connection point (V1, Vn) between load (L1, Ln) and power circuit breaker (T1, Tn, IC1, ICn) is connected to the cathode terminal of a diode (D1, Dn) and **in that** the positive temperature coefficient resistor (PTC) is connected between the connected anode terminals of the diodes (D1, Dn) and the earth connection (M) of the controller (SG).

5. Controller according to Claim 1, **characterized in that** the driver circuit (A) [is provided with] a voltage monitoring device (SÜ) [which] monitors the potential (U_{PTC}).

6. Controller according to any one of the abovementioned claims, **characterized in that** the voltage monitoring device (SÜ) monitors the potential (U_{PTC}) at the anode terminals of the diodes (D1, Dn) and **in that** the driver circuit ceases driving all power circuit breakers (T1, Tn, IC1, ICn) when the difference between the monitored potential (U_{PTC}) and the potential of the positive pole (+) of the voltage source (B) falls below a specified value.

## Revendications

1. Appareil de commande (SG) équipé d'un circuit de protection de l'appareil de commande lors de l'interruption de la masse de l'appareil de commande (MASSE1), en particulier dans des véhicules automobiles, avec au moins un interrupteur de charge électronique (T1, Tn, IC1, ICn), avec respectivement une charge (L1, Ln), qui est disposée entre le pôle négatif (-) d'une source de tension (B) et une première électrode (S) de l'interrupteur de charge respectif (T1, Tn, IC1, ICn) et peut être reliée par l'intermédiaire d'une seconde électrode (D) de l'interrupteur de charge (T1, Tn, IC1, ICn) au pôle positif (+) de la source de tension (B), et avec un circuit de commande (A), qui commande une électrode de commande (G) de l'interrupteur de charge respectif (T1, Tn, IC1, ICn) en vue de l'actionnement de l'interrupteur de charge (T1, Tn, IC1, ICn), **caractérisé en ce qu'**entre les points de liaison (V1, Vn) d'interrupteurs de charge (T1, Tn, IC1, ICn) et de charges (L1, Ln) et la connexion de masse (M) de l'appareil de commande (SG) est monté un circuit de protection (SE), qui se compose d'un circuit série comportant une diode (D1, Dn) pour chaque point de liaison (V1, Vn) et une résistance à coefficient de température positif (PTC).

2. Appareil de commande selon la revendication 1, **caractérisé en ce que** le au moins un interrupteur de charge électronique est constitué par un transistor à effet de champ MOS de puissance à canal n.

3. Appareil de commande selon la revendication 1, **caractérisé en ce que** le au moins un interrupteur de charge électronique est réalisé sous la forme d'un composant pilote intégré High-Side (IC1, ICn).

4. Appareil de commande selon la revendication 1, **caractérisé en ce que** l'appareil de commande (SG) présente plusieurs interrupteurs de charge (T1, Tn, IC1, ICn) en vue de la commande respective d'une charge (L1, Ln), et **en ce que** chaque point de liaison (V1, Vn) entre une charge (L1, Ln) et un interrupteur de charge (T1, Tn, IC1, ICn) est relié à la borne de cathode d'une diode (D1,Dn) et **en ce qu'**entre les bornes d'anode réunies des diodes (D1, Dn) et la connexion de masse (M) de l'appareil de commande (SG) est montée la résistance à coefficient de température positif (PTC).

5. Appareil de commande selon la revendication 1, **caractérisé en ce que** le circuit de commande (A) surveille un dispositif de surveillance de tension (SÜ) du potentiel (U_{PTC}).

6. Appareil de commande selon une des revendications précédentes, **caractérisé en ce que** le dispositif de surveillance de tension (SÜ) surveille le potentiel (U_{PTC}) sur les bornes d'anode des diodes (D1, Dn) et **en ce que** le circuit de commande met fin à la commande de tous les interrupteurs de charge (T1, Tn, IC1, ICn), lorsque la différence de potentiel entre le potentiel surveillé (U_{PTC}) et le potentiel du pôle positif (+) de la source de tension (B) tombe au-dessous d'une valeur prescrite.
